Europäisches Patentamt

European Patent Office

Office européen des brevets

(11) Veröffentlichungsnummer: **0 400 539**
**A2**

## (12) EUROPÄISCHE PATENTANMELDUNG

(21) Anmeldenummer: 90110086.7

(22) Anmeldetag: 28.05.90

(51) Int. Cl.⁵: **H01R 23/68**

(30) Priorität: **31.05.89 DE 8906679 U**

(43) Veröffentlichungstag der Anmeldung:
**05.12.90 Patentblatt 90/49**

(84) Benannte Vertragsstaaten:
**AT BE CH DE FR GB IT LI NL**

(71) Anmelder: **Siemens Aktiengesellschaft**
**Wittelsbacherplatz 2**
**D-8000 München 2(DE)**

(72) Erfinder: **Wessely, Hermann, Dipl.-Ing.**
**Paul-Hösch-Strasse 1**
**D-8000 München 60(DE)**

(54) **Steckkontaktvorrichtung für Leiterplatten.**

(57) Eine Steckkontaktvorrichtung für Leiterplatten weist eine Vielzahl von senkrecht aus der Leiterplattenebene herausragenden stiftförmigen Kontaktelementen auf, die sich mit einem Ende auf Kontaktflächen an der ihnen zugewandten Leiterplattenoberfläche abstützen und mit diesen verbunden sind.

EP 0 400 539 A2

## Steckkontaktvorrichtung für Leiterplatten

Die Erfindung betrifft eine Steckkontaktiervorrichtung für Leiterplatten mit einer Vielzahl von senkrecht aus der Leiterplattenebene herausragenden stiftförmigen Kontaktelementen.

Solche Steckkontaktiervorrichtungen sind bereits als sogenannte Steckerleisten bekannt, bei denen eine Vielzahl von stiftförmigen Kontaktelementen in einer oder auch mehreren parallelen Reihen angeordnet und mittels eines Kunststoffgehäuses zusammengehalten sind.

Diese bekannten Steckerleisten werden auf Leiterplatten, vor allem auf sogenannten "Plattern" vorgesehen, um eine lösbare Mehrfachverbindung mit Leitungen, oder Bauelementeträgern, wie z.B. Flachbaugruppen, zu ermöglichen. Diese müssen natürlich mit entsprechenden Buchsen zur Aufnahme der Kontaktelemente versehen sein.

Zum Anschluß an eine Leiterplatte sind die stiftförmigen Kontaktelemente der bekannten Steckerleisten mit einem Ende durch ein jeweiliges Durchkontaktierungsloch in der Leiterplatte hindurchgeführt und an der, dem Steckergehäuse gegenüberliegenden Seite der Leiterplatte angelötet. Die dazu erforderlichen Durchkontaktierungslöcher müssen gegenüber dem Durchmesser bzw. der Kantenlänge der stiftförmigen Kontaktelemente ein Übermaß aufweisen, um nicht schon bei geringfügigen Unregelmäßigkeiten der Abstände zwischen den stiftförmigen Kontaktelementen einer Steckerleiste die Montage dieser Steckerleiste auf der Leiterplatte zu behindern.

Die Durchkontaktierungslöcher beanspruchen damit relativ große Flächen, die auch auf sämtlichen Innenlagen der Leiterplatte für eine Anordnung von Leiterbahnen nicht mehr zur Verfügung stehen. Unter Umständen werden zusätzliche Leiterplattenlagen benötigt, die wiederum einen erhöhten Aufwand bei der Herstellung der Leiterplatten erfordern.

Aufgabe der vorliegenden Erfindung ist es daher, eine Steckkontaktvorrichtung nach dem Oberbegriff des Schutzanspruchs 1 so auszubilden, daß der für die Steckkontaktvorrichtung notwendige Platzbedarf zugunsten einer möglichst optimalen Flächennutzung für die Leiterbahnstrukturen einer gegebenenfalls mehrlagigen Leiterplatte so gering wie möglich gehalten werden kann.

Gelöst wird diese Aufgabe erfindungsgemäß dadurch, daß sich die stiftförmigen Kontaktelemente mit einem Ende auf an der ihnen zugewandten Leiterplattenoberfläche befindlichen Kontaktflächen abstützen und mit diesen verbunden sind.

Für den Anschluß einer erfindungsgemäß ausgebildeten Steckkontaktvorrichtung müssen lediglich Kontaktflächen an einer Oberfläche der Leiterplatte vorgesehen werden. Sämtliche Innenlagen und die abgewandte Oberfläche der Leiterplatte werden durch die Steckkontaktvorrichtung nicht beeinflußt.

Auch kann der Querschnitt der stiftförmigen Kontaktelemente bei Bedarf geändert werden, ohne daß dafür Eingriffe auf der Leiterplatte erforderlich sind.

Besonders vorteilhaft ist die erfindungsgemäß ausgebildete Steckkontaktvorrichtung für eine gegenüberliegende Anordnung auf beiden Seiten einer Leiterplatte, weil die stiftförmigen Kontaktelemente auf beiden Seiten sehr dicht nebeneinander angeordnet sein können (bei bekannten Steckerleisten muß zwischen zwei Kontaktelementen noch ausreichend Platz für ein Kontaktelement der gegenüberliegenden Steckerleiste bleiben), und sich damit eine sehr hohe Kontaktelementedichte pro Leiterplattenfläche erzielen läßt.

Vorteilhafte Weiterbildungen der Erfindung sind in den Unteransprüchen angegeben.

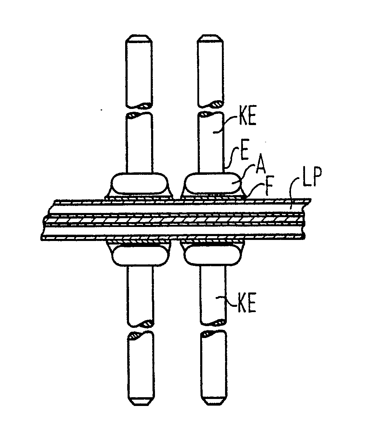

Ein Ausführungsbeispiel der Erfindung wird im folgenden anhand der Zeichnung näher erläutert.

Die FIG zeigt einen Querschnitt durch ein Teilstück einer Leiterplatte LP, die auf beiden Seiten mit stiftförmigen Kontaktelementen KE versehen ist. Die Leiterplatte LP ist als herkömmliche, mehrlagige Epoxid- Leiterplatte ausgebildet und soll als "Platter" zum beidseitigen Anschluß von Bauelementeträgern dienen. Zur Bildung von elektrischen Verbindungen zwischen den einzelnen Lagen ist die Leiterplatte LP mit einer Vielzahl von äußerst kleinen Durchkontaktierungslöchern (nicht dargestellt) versehen.

Die stiftförmigen Kontaktelemente KE bestehen jeweils aus einem geraden, zylinderförmigen Steckerstift, der an einem Ende E zu einem Anschlußfuß A verbreitert ist und sich am anderen Ende kegelstumpfförmig verjüngt.

Jedes stiftförmige Kontaktelement KE steht senkrecht zur Leiterplattenebene und stützt sich mit seinem Anschlußfuß A auf einer an der ihm zugewandten Oberfläche der Leiterplatte LP angeordneten Kontaktfläche KF ab. Der Anschlußfuß A, der als eine zur Kontaktelementeachse radial symmetrische Verbreiterung ausgebildet ist, ist mit der jeweiligen Kontaktfläche verlötet.

Die stiftförmigen Kontaktelemente KE sind an beiden Seiten der Leiterplatte LP so zueinander ausgerichtet, daß sich jeweils zwei stiftförmige Kontaktelemente KE fluchtend gegenüberstehen.

Ein Gehäuse für die stiftförmigen Kontaktelemente KE ist nicht vorhanden.

**Ansprüche**

1. Steckkontaktvorrichtung für Leiterplatten mit einer Vielzahl von senkrecht aus der Leiterplattenebene herausragenden stiftförmigen Kontaktelementen, **dadurch gekennzeichnet,** daß sich die stiftförmigen Kontaktelemente (KE) mit einem Ende auf an der ihnen zugewandten Leiterplattenoberfläche befindlichen Kontaktflächen (F) abstützen und mit diesen verbunden sind.

2. Steckkontaktvorrichtung nach Anspruch 1, **dadurch gekennzeichnet,** daß die stiftförmigen Kontaktelemente (KE) jeweils ein zu einem Anschlußfuß (A) für eine Lötverbindung verbreitertes Ende (E) aufweisen.

3. Steckkontaktvorrichtung nach Anspruch 1 oder 2, **dadurch gekennzeichnet,** daß der Anschlußfuß (A) als eine zur Kontaktelementeachse radialsymmetrisch angeordnete Verbreiterung ausgebildet ist.

4. Steckkontaktvorrichtung nach einem der vorhergehenden Ansprüche, **dadurch gekennzeichnet,** daß die stiftförmigen Kontaktelemente (KE) an beiden Seiten der Leiterplatte (LP) angeordnet sind.

5. Steckkontaktvorrichtung nach Anspruch 4, **dadurch gekennzeichnet,** daß die stiftförmigen Kontaktelemente (KE) jeweils fluchtend zueinander angeordnet sind.

6. Steckkontaktvorrichtung nach einem der vorhergehenden Ansprüche, **dadurch gekennzeichnet,** daß die stiftförmigen Kontaktelemente (KE) nebeneinander gehäuselos angeordnet sind.